# EUROPEAN PATENT APPLICATION

(11) **EP 1 742 523 A2**
(43) Date of publication of application: **10.01.2007**
(21) Application number: 05112264.6
(22) Date of filing: 15.12.2005
(51) Int. Cl.: H05K 7/10, G01R 1/04

(54) **Memory module with chip fixture**

(30) Priority: 23.06.2005 CN 200520110430
(71) Applicant: Tzu, Chung-Hsing, Rugo 226500 Jiansu Province (CN)
(72) Inventor: Tzu, Chung-Hsing, Rugo 226500 Jiansu Province (CN)
(74) Representative: Beck, Michael Rudolf

(57) **Abstract**

A memory module with chip hold-down fixture includes a substrate, a plurality of sockets provided on one surface of the substrate and having conductive terminals provided on a bottom thereof for electrically connecting to circuits on the substrate, and a hold-down fixture assembled to a top of each socket. Each of the sockets is symmetrically provided at two opposite end walls with a retaining section each. The hold-down fixture is provided at two opposite end walls with a receiving section each corresponding to the retaining section on the socket, and at two lateral sides with a press portion each. The hold-down fixture is assembled to the top of the socket through engagement of the receiving sections with the retaining sections, so that the press portions are pressed against a chip positioned in the socket for the chip to contact with and electrically connect to the conductive terminals in the socket.

## Description

### FIELD OF THE INVENTION

The present invention relates to a memory module, and more particularly to a memorymodule with chip hold-down fixture that allows differently sized chips to removably mount thereon.

### BACKGROUND OF THE INVENTION

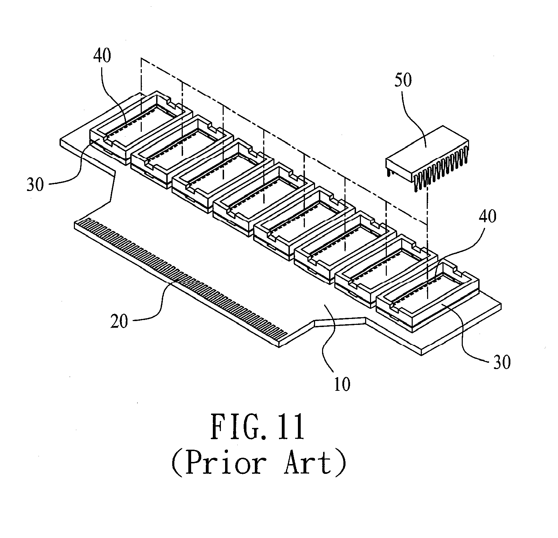

In the existing chip packaging process, each packaged chip is subjected to test, so that chips with stable operating function or efficiency are screened and selected to ensure good quality of the produced chips and reduce the bad yield as well as the subsequent warranty cost of the electronic products using the chips. Fig. 11 shows a conventional chip test device, which includes a circuit board 10 having a plurality of signal contacts 20 provided at a predetermined edge thereof, and a plurality of chip sockets 30 provided on one surface of the circuit board 10. Each of the chip sockets 30 allows a chip 50 to be easily inserted thereinto and pulled therefrom, and is internally provided with signal contacts 40, holdingmeans, and other elements. When the circuit board 10 is connected to a motherboard or other test device via the signal contacts 20, chips 50 may be separately positioned in the chip sockets 30, and a test for the quality of the chips 50 may be conducted.

With the quickly developed semiconductor packaging technique, there are many different types of chip packages available for various electronic products. Since differently packaged chips could not be tested using the same type of chip test device, a chip manufacturer has to change the design for the signal contacts 40, the holding means, and other elements in the chip sockets 30 from time to time to adapt to the chips to be tested. These changes in the design of the chip sockets 30 might encounter many technical bottlenecks and would increase the manufacturing and managing costs.

Meanwhile, a conventional memory module usually includes a plurality of memory chips directly soldered to a circuit board. In the event of any damaged or defective memory chip on the memory module, it is difficult to repair or replace the damaged or defective memory chip.

### SUMMARY OF THE INVENTION

It is therefore a primary object of the present invention to provide a memory module with chip hold-down fixture that may be connected to a motherboard of a computer for use or to other test devices to serve as a testing fixture.

Another object of the present invention is to provide a memory module with chip hold-down fixture that allows differently sized chips to be easily removably mounted on the memory module.

To achieve the above and other objects, the memory module with chip hold-down fixture according to the present invention includes a substrate having circuits, electronic elements, and a plurality of circuit contacts provided thereon; a plurality of sockets provided on one surface of the substrate; and a hold-down fixture assembled to a top of each socket. Each of the sockets defines a receiving space, on a bottom of which a plurality of conductive terminals are provided for electrically connecting to the circuit contacts on the substrate. The socket is symmetrically provided at two opposite end walls with a retaining section each. The hold-down fixture is provided at two opposite end walls with a receiving section each corresponding to the retaining section on the socket, and at two lateral sides with a press portion each. The hold-down fixture is assembled to the top of one or more sockets through engagement of the receiving sections with the retaining sections, so that the press portions on the hold-down fixture are pressed against chips separately positioned in the receiving spaces of the sockets for the chips to contact with and electrically connect to the conductive terminals in the sockets.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 is a schematic and partially exploded perspective view of a memory module with chip hold-down fixture according to a first embodiment of the present invention;
Fig. 2 is a perspective view showing the assembling of a hold-down fixture to a chip socket on the memory module of Fig. 1;
Fig. 3 is an exploded perspective view of Fig. 2;
Fig. 4 is a fragmentary sectional view showing the memory module of Fig. 1 in use;
Fig. 5 is an exploded perspective view of a memory module with hold-down fixture according to a second embodiment of the present invention;
Fig. 6 is a fragmentary sectional view of a memory module with hold-down fixture according to a third embodiment of the present invention;
Fig. 7 is a partially exploded perspective view of a memory module with hold-down fixture according to a fourth embodiment of the present invention;
Fig. 8 is a fragmentary sectional view of Fig. 7;
Fig. 9 is an exploded perspective view of a memory module with hold-down fixture according to a fifth embodiment of the present invention;
Fig. 10 is a fragmentary sectional view of Fig. 9; and
Fig. 11 is a partially exploded perspective view of a conventional chip test device.

### DETAILED DESCRIPTION OF THE PREFERRED EMBODIMENTS

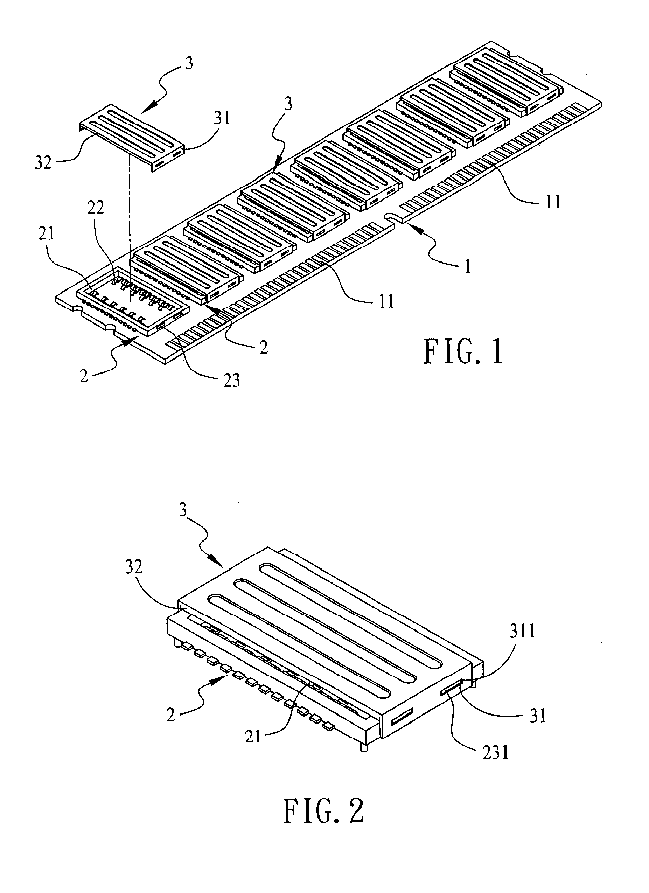

Please refer to Fig. 1 that is a partially exploded perspective view of a memory module with hold-down fixture according to a first embodiment of the present invention. The memory module may be connected to a motherboard of a computer for use or to other test devices to serve as a testing fixture. As shown, the memory module includes a substrate 1, a plurality of sockets 2 provided on the substrate 1, and a plurality of hold-down fixtures 3 corresponding to the sockets 2.

The substrate 1 may be a printed circuit board, on which necessary circuits, electronic elements, and a plurality of contacts for electrically connected to the sockets 2 are provided. An electrical connection section 11 is provided along a selected edge of the substrate 1 for quickly inserting onto the motherboard or other test devices.

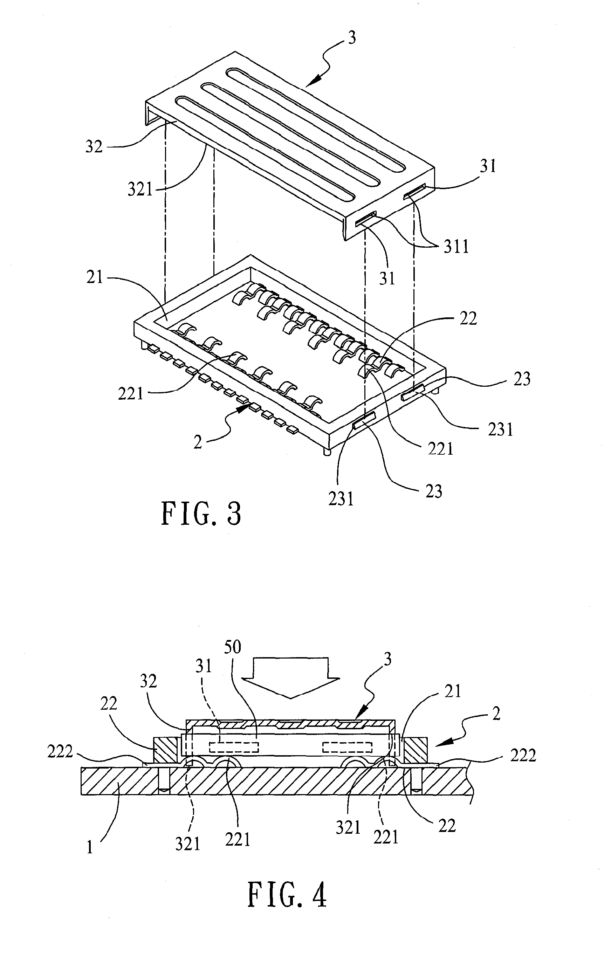

The sockets 2 are insulating seats provided on a surface of the substrate 1 for receiving a chip each. Please refer to Figs. 1 to 4 at the same time. Each of the sockets 2 defines a receiving space 21, on a bottom of which a plurality of conductive terminals 22 are provided for electrically connecting to a plurality of circuit contacts provided on the substrate 1. The socket 2 is symmetrically provided on outer sides of two opposite end walls with a retaining section 23 each. The receiving space 21 may be a recess or a through opening. The conductive terminals 22 may be arranged in two rows located at two lateral sides on the bottom of the receiving space 21 (see Fig. 3), or arrayed in four rows or in other manners. Each of the conductive terminals 22 has an inner end extended into the receiving space 21 to form a curved contact section 221, and an outer end projected from the socket 2 to form a soldering section 222 (see Fig. 4). The retaining section 23 may be one or more beveled tenons 231 integrally formed on each of the two opposite end walls of the socket 2.

Please refer to Figs. 1 to 4. The hold-down fixture 3 may be formed by way of pressing a sheet metal into a substantially U-shaped member having two downward symmetrical end walls. Alternatively, the hold-down fixture 3 may be differently shaped, so long as it provides the same holding down function. The hold-down fixture 3 is provided on the two symmetrical end walls with a receiving section 31 each. The hold-down fixture 3 has two lateral sides that downward extend by a predetermined distance to form a press portion 32 each, a lower edge of which is formed into a press end 33 for pressing against a chip 50 positioned in the socket 2. The receiving section 31 may be one or more through holes 311 corresponding to the beveled tenons 231.

When the receiving sections 31 on the hold-down fixture 3 engage with the retaining sections 23 on the socket 2, the hold-down fixture 3 is held to a top of the socket 2 to press against the chip 50 positioned in the receiving space 21 of the socket 2, so that the chip 50 is electrically connected to the conductive terminals 22.

To use the memory module with chip hold-down fixture according to the first embodiment of the present invention, first position chips 50 in the receiving spaces 21 of the sockets 2 one by one, so that an external conducting section on each of the chips 50 is in contact with and electrically connected to the contact sections 221 of the conductive terminals 22. Then, position the hold-down fixture 3 on the top of each socket 2 to engage the receiving sections 31 (that is, the through holes 311) on the two end walls of the hold-down fixture 3 with the retaining sections 23 (that is, the beveled tenons 231) on the two end walls of the socket 2, so that the press ends 33 at the two lateral sides of the hold-down fixture 3 are tightly pressed against the chip 50 for the latter to locate in place and firmly contact with the conductive terminals 22 in the socket 2. With the above arrangements, the hold-down fixture 3 may be easily and firmly assembled to the socket 2. Moreover, since the chip 50 in each socket 2 is always downward pressed against the conductive terminals 22 in the socket 2 by the press ends 33 of the hold-down fixture 3, it is not necessary to change the structural design of the socket 2 due to any change in the size of the chip 50. As a result, the same memory module of the present invention may be used to receive or test chips 50 of different sizes to thereby largely reduce costs for making and managing testing fixtures.

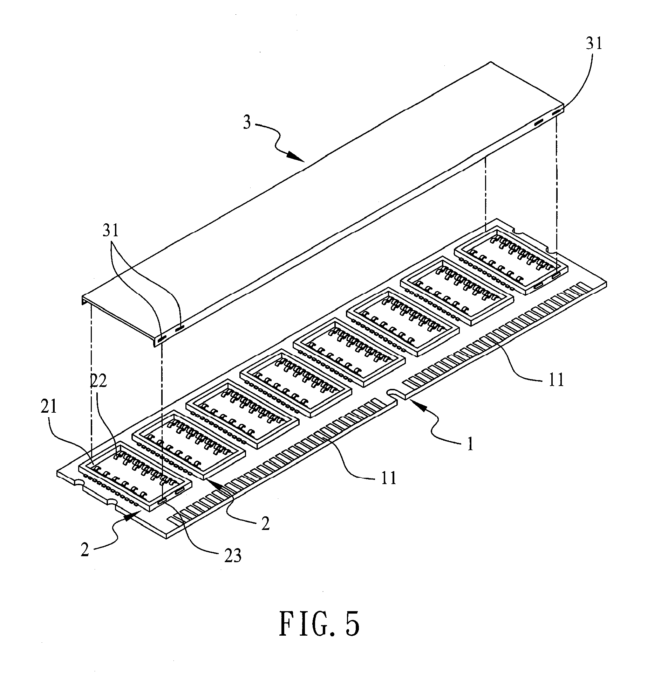

Please refer to Fig. 5 in which a memory module with hold-down fixture according to a second embodiment of the present invention is shown. In the second embodiment, the memory module includes a substrate 1 and a plurality of sockets 2 similar to those in the first embodiment. The hold-down fixture 3 in the second embodiment is also structurally similar to that in the first embodiment but has a large size for covering a plurality of sockets 2 at the same time. The sockets 2 are provided on the two end walls with a retaining section 23 each, and the hold-down fixture 3 is provided on the two end walls with a receiving section 31 each corresponding to the retaining sections 23 on the sockets 2, so that a plurality of chips 50 may be simultaneously pressed against the sockets 2 to electrically connect to the conductive terminals 22 through only one assembling of the large-size hold-down fixture 3 to the sockets 2.

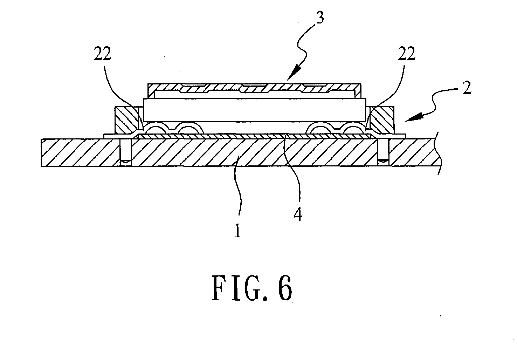

Fig. 6 is a sectional view showing a memory module with chip hold-down fixture according to a third embodiment of the present invention. The third embodiment is generally structurally similar to the first embodiment and the second embodiment, except that an elastic pad 4 is provided below the conductive terminals 22 in each socket 2 to protect the contact sections 221 of the conductive terminals 22 against elastic fatigue due to frequent compression by the hold-down fixture 3, so as to ensure a good elastic contact of the conductive terminals 22 with the chip 50.

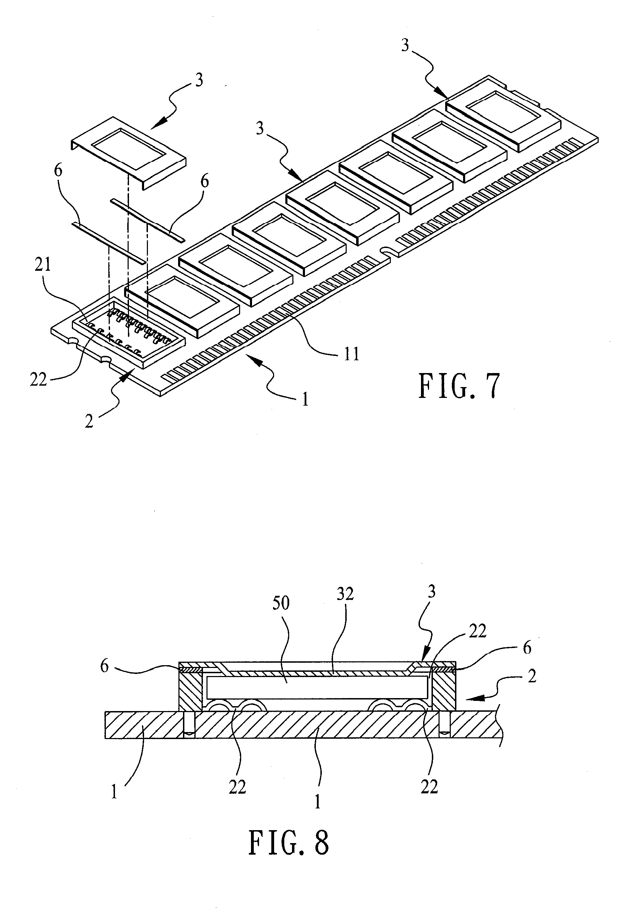

Figs. 7 and 8 are perspective and sectional views, respectively, of a memory module with hold-down fixture according to a fourth embodiment of the present invention. In the fourth embodiment, the memory module also includes a substrate 1 and a plurality of sockets 2 similar to those in the previous embodiments. However, the sockets 2 and the hold-down fixtures 3 in the fourth embodiment do not include any retaining section and receiving section, respectively. In the fourth embodiment, one or more adhesive tapes 6 are attached to the top of each socket 2, and the hold-down fixture 3 includes a downward protruded press portion 32 formed at an underside of the hold-down fixture 3, so that a bottom surface of the press portion 32 serves as a press end 33. The hold-down fixture 3 is connected to the top of the socket 2 via the adhesive tapes 6, so that the press portion 32 is pressed against the chip 50 for the same to electrically contact with the conductive terminals 22 in the socket 2.

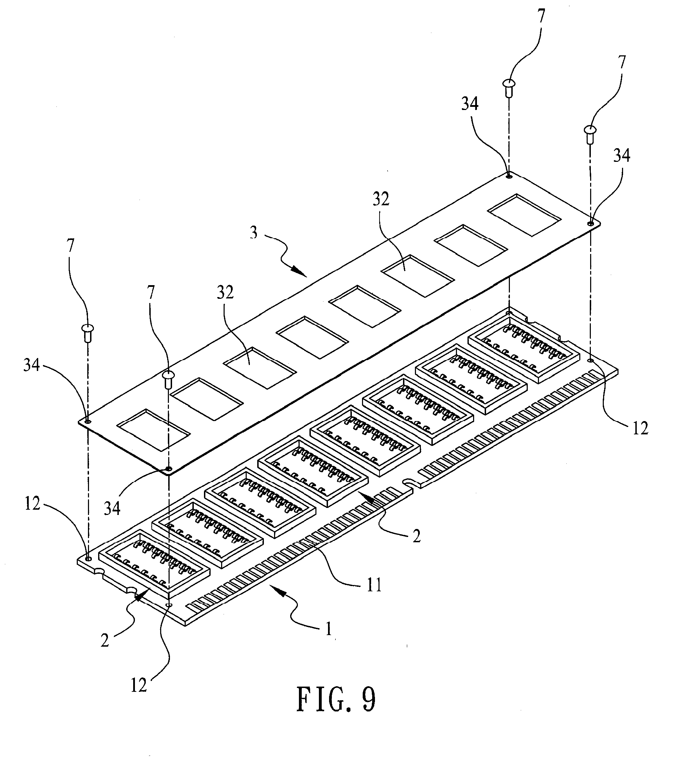

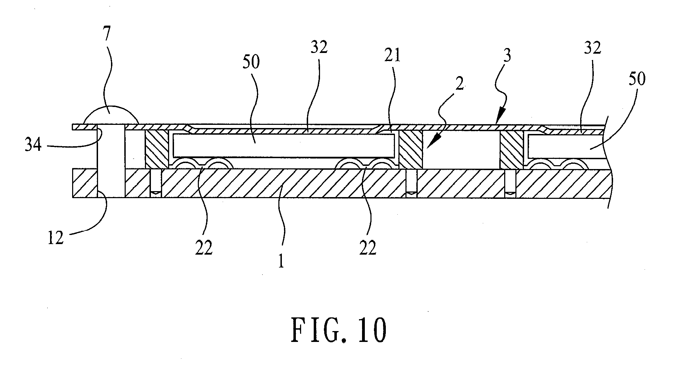

Figs. 9 and 10 are perspective and sectional views, respectively, of a memory module with chip hold-down fixture according to a fifth embodiment of the present invention. In the fifth embodiment, the substrate 1 is structurally similar to those in the previous embodiments, but further provided at predetermined positions with a fixing hole 12 each; the sockets 2 are structurally similar to those in the previous embodiments, but do not include any retaining section; and the hold-down fixture 3 is a large-size plate adapted to cover a plurality of sockets 2 at the same time. The hold-down fixture 3 in the fifth embodiment does not include any receiving section, but is formed at an underside with a plurality of downward protruded press portions 32, so that a bottom surface of each press portion 32 serves as a press end 33, and at predetermined positions with a plurality of through holes 34 corresponding to the fixing holes 12 on the substrate
1. The hold-down fixture 3 is positioned on the top of the sockets 2 and connected to the substrate 1 by rivets 7 separately extended through corresponding through holes 34 and fixing holes 12, so that each of the press sections 32 at the underside of the hold-down fixture 3 is pressed against one chip 50 for the same to contact with and electrically connect to the conductive terminals 22 in the socket 2.

## Claims

1. Amemorymodule with chip hold-down fixture, comprising a substrate, a plurality of sockets being provided on one surface of said substrate and having a plurality of conductive terminals provided on a bottom thereof, and at least one hold-down fixture assembled to a top of said sockets; each of said sockets being symmetrically provided at two opposite end walls with a retaining section each; said at least one hold-down fixture being made of a sheet material, and being symmetrically provided at two opposite end walls with a receiving section each, and at two lateral sides with a downward extended press portion each, so that a lower edge of each said press portion serves as a press end; and said at least one hold-down fixture being assembled to the top of said sockets through engagement of said receiving sections on said at least one hold-down fixture with said retaining sections on said sockets, such that said press ends at two lateral sides of said at least one hold-down fixture downward press against chips separately positioned in said sockets for said chips to contact with and electrically connect to said conductive terminals provided on the bottom of said sockets.

2. The memory module with chip hold-down fixture as claimed in claim 1, wherein each of said retaining sections includes one or more beveled tenons integrally formed on each of said end walls of said socket, and each of said receiving sections includes one or more through holes formed on each of said end walls of said hold-down fixture corresponding to said beveled tenons.

3. The memory module with chip hold-down fixture as claimed in claim 1, wherein said at least one hold-down fixture has a size adapted to cover the top of more than one said socket at the same time.

4. The memory module with chip hold-down fixture as claimed in claim 1, further comprising an elastic pad provided below said conductive terminals on the bottom of each said socket.

5. Amemorymodule with chip hold-down fixture, comprising a substrate, a plurality of sockets being provided on one surface of said substrate and having a plurality of conductive terminals provided on a bottom thereof, and at least one hold-down fixture assembled to a top of said sockets; each of said sockets being provided on a top surface with at least one adhesive tape, and said at least one hold-down fixture being made of a sheet material and including a downward protruded press portion formed at an underside of said hold-down fixture, so that a bottom surface of said press portion serves as a press end; and said at least one hold-down fixture being assembled to the top of said sockets via said adhesive tapes, so that said press portion is pressed against chips separately positioned in said sockets for said chips to contact with and electrically connect to said conductive terminals provided on the bottom of said sockets.

6. The memory module with chip hold-down fixture as claimed in claim 5, wherein said at least one hold-down fixture has a size adapted to cover the top of more than one said socket at the same time.

7. The memory module with chip hold-down fixture as claimed in claim 5, further comprising an elastic pad provided below said conductive terminals on the bottom of each said socket.

8. Amemorymodule with chip hold-down fixture, comprising a substrate, a plurality of sockets being provided on one surface of said substrate and having a plurality of conductive terminals provided on a bottom thereof, and at least one hold-down fixture assembled to a top of said sockets; said substrate being provided at predetermined positions with a plurality of fixing holes; said at least one hold-down fixture being made of a sheet material and having a size adapted to cover the top of more than one said socket at the same time, and being provided at an underside with a plurality of downward protruded press portions, each of which has a bottom surface serving as a press end, and at predetermined positions with a plurality of through holes corresponding to said fixing holes on said substrate; and said at least one hold-down fixture being assembled to the top of said sockets by rivets extended through said through holes on said hold-down fixture and said fixing holes on said substrate, so that said press portions on said at least one hold-down fixture are pressed against chips separately positioned in said sockets for said chips to contact with and electrically connect to said conductive terminals provided on the bottom of said sockets.

9. The memory module with chip hold-down fixture as claimed in claim 8, further comprising an elastic pad provided below said conductive terminals on the bottom of each said socket.
